# EUROPÄISCHE PATENTSCHRIFT

(11) **EP 2 115 793 B1**
(45) Veröffentlichungstag und Bekanntmachung des Hinweises auf die Patenterteilung: **11.01.2012**
(21) Anmeldenummer: 08707459.7
(22) Anmeldetag: 31.01.2008
(51) Int. Cl.: H01L 47/02

(54) **GUNN-DIODE**
GUNN DIODE
DIODE GUNN

(30) Priorität: 09.02.2007 DE 102007007159
(43) Veröffentlichungstag der Anmeldung: 11.11.2009
(73) Patentinhaber: Technische Universität Darmstadt, 64289 Darmstadt (DE)
(72) Erfinder: YILMAZOGLU, Oktay, 64846 Gross-Zimmern (DE); MUTAMBA, Kabula, 93080 Pentling (DE); PAVLIDIS, Dimitris, 65824 Schwalbach (DE); KARADUMAN, Tamer, 85368 Moosburg (DE)
(74) Vertreter: Tergau & Walkenhorst
(86) Internationale Anmeldenummer: PCT/EP2008/000772
(87) Internationale Veröffentlichungsnummer: WO 2008/095639

(56) Entgegenhaltungen:
- WO-A-2006/029607
- ZYBURA M F ET AL: "125-145 GHz stable depletion layer transferred electron oscillators" SOLID STATE ELECTRONICS, ELSEVIER SCIENCE PUBLISHERS, BARKING, GB, Bd. 39, Nr. 4, 1. April 1996 (1996-04-01), Seiten 547-553, XP004006553 ISSN: 0038-1101
- LEE D H ET AL: "Ion-implanted n<+> contacts for Ka band GaAs Gunn-effect diodes" ELECTRONICS LETTERS, IEE STEVENAGE, GB, Bd. 11, Nr. 9, 1. Mai 1975 (1975-05-01), Seiten 189-191, XP009102298 ISSN: 0013-5194
- A.A. KAL'FA: "Physics of short Gunn diodes with a double-zone cathode" SOV. PHYS. TECH. PHYS., Bd. 28, Nr. 1, Januar 1983 (1983-01), Seiten 129-130, XP009102629
- ARKUSHA YU V ET AL: "An antibarrier metal cathode contact to short Gunn diodes" SOVIET JOURNAL OF COMMUNICATIONS TECHNOLOGY AND ELECTRONICS, SCRIPTA TECHNICA, SILVER SPRING, MD, US, Bd. 33, Nr. 11, 1. November 1988 (1988-11-01), Seiten 87-89, XP009102305 ISSN: 8756-6648
- OSHIO K ET AL: "Chaotic current oscillations in the Gunn-effect device under the DC and the RF bias voltages" JOURNAL OF THE PHYSICAL SOCIETY OF JAPAN, PHYSICAL SOCIETY OF JAPAN. TOKYO, JP, Bd. 62, Nr. 10, 1. Oktober 1993 (1993-10-01), Seiten 3639-3650, XP009102329 ISSN: 0031-9015

## Beschreibung

Die Erfindung bezieht sich auf eine Gunn-Diode, deren aktive Schicht ober- und unterseitig jeweils an eine benachbarte, im Vergleich zur aktiven Schicht höher dotierte Kontaktschicht desselben Materials angrenzt.

Als Gunn-Dioden werden Halbleiterbauelemente bezeichnet, die hauptsächlich zur Erzeugung von Hochfrequenzstrahlung im GHz-Frequenzbereich genutzt werden. Aufgrund der niedrigen Herstellungskosten und dem vergleichsweise geringen Herstellungsaufwand kommen Gunn-Dioden in weiten Bereichen der Informationstechnologie, in denen Hochfrequenzsender benötigt werden, zum Einsatz.

Die Funktionsweise einer Gunn-Diode beruht auf dem so genannten Gunn-Effekt. Es handelt sich hierbei um einen Hochfeldstärkeeffekt, der in bestimmten Halbleitermaterialien, wie z.B. GaAs oder InP, auftritt. Die Energiebänder dieser Halbleiter haben relative Maxima und Minima in einem nicht großen energetischen Abstand. Elektronen, die zum Beispiel aus einem Valenzband in ein Leitungsband angeregt wurden, befinden sich zunächst im absoluten Minimum des Leitungsbandes. Erreichen diese Elektronen in einem elektrischen Feld eine Energie, die im Bereich der Energiedifferenz der Minima liegt (bei GaAs 0.29 eV), so werden sie durch optische Phononen in das benachbarte Minimum gestreut. Aufgrund der hohen effektiven Masse der Elektronen im benachbarten Minimum, dem so genannten Seitental, haben sie dort eine kleinere Beweglichkeit. Es ergibt sich dann ein sinkender Strom bei steigender Spannung, d.h. ein negativer differentieller Widerstand.

Dieser Effekt wird in der Gunn-Diode ausgenutzt, indem durch geeignete Beschaltung bewirkt wird, dass Elektronen sich aufstauen und in Schüben (wie Wellen) durch die Diode wandern. Dies wiederum resultiert in einer Abstrahlung elektromagnetischer Wellen entsprechend dieser Frequenz.

In der Praxis werden Bauelemente auf der Grundlage dieses Gunn-Effekts üblicherweise als Halbleiterbauelemente in Dünnschichttechnologie hergestellt, so dass die notwendigen Randbedingungen hinsichtlich reproduzierbarer mikroskopischer Eigenschaften und dergleichen eingehalten werden können. Der die elektrischen Eigenschaften bestimmende aktive Teil einer derartigen Gunn-Diode setzt sich dabei aus drei unterschiedlich dotierten Schichten zusammen, die aufeinander angeordnet sind. Die mittlere Schicht stellt dabei die so genannte aktive Schicht dar, da in ihr der für die Gunn-Diode charakteristische Gunn-Effekt auftritt. Die beiden weiteren Schichten sind im Vergleich zur aktiven Schicht höher dotiert.

In einer derartigen Anordnung wird aufgrund der genannten Dotierungsfolge und der dadurch resultierenden Leitfähigkeitsunterschiede in der aktiven Schicht eine Elektronendomäne gebildet, in der sich Elektronen ansammeln sobald eine bestimmte Schwellenfeldstärke erreicht ist. Als Basismaterial für die aktive Schicht und die beiden benachbarten Kontaktschichten wird dabei üblicherweise dasselbe Material gewählt, so dass die kristallographischen Eigenschaften des Materials über die Grenzfläche hinweg unverändert bleiben und Störeffekte aufgrund von Kristalleffekten weitgehend vermieden sind. Die gewünschten Unterschiede in der Leitfähigkeit zwischen aktiver Schicht und den benachbarten Kontaktschichten werden dabei ausschließlich durch Änderungen der Dotierung erreicht. In der Regel wird dabei Galliumarsenid (GaAs) oder auch Indiumphosphid (InP) als Basismaterial verwendet.

Die erzielten Frequenzen und die Leistung einer Gunn-Diode in derartiger Bauweise hängen dabei unter anderem vom verwendeten Basis-Material ab. Andererseits werden insbesondere in technologischen Anwendungen wie auch bei anderen Halbleiterbauelementen in Dünschicht-Bauweise die Reproduzierbarkeit der Bauteileigenschaften und auch die allgemeine Zuverlässigkeit bei variierenden Einsatzbedingungen unter anderem von bauartbedingten Einschränkungen wie beispielsweise den Kontaktwiderständen begrenzt. Gerade die Stabilität und Zuverlässigkeit einer Gunn-Diode kann darüber hinaus durch thermische Erwärmung der Bauelemente beziehungsweise Überhitzung einerseits und Elektromigration und elektrische Entladungen in der Umgebungsatmosphäre andererseits beeinträchtigt werden. Durch zu hohe Kontaktwiderstände können zudem betriebsbedingt unerwünschte Störeffekte wie beispielsweise Rauschen und dergleichen auftreten. Es besteht dabei insbesondere im Hinblick auf breite technologische Anwendbarkeit und industrielle Fertigungsmöglichkeiten das Bestreben, diese Effekte möglichst gering zu halten.

Eine Gunn-Diode der oben genannten Art mit einer in ihrem Außenbereich noch höher dotierten Kontaktschicht ist aus der WO 2006/029607 A1 bekannt.

Der Erfindung liegt die Aufgabe zu Grunde, eine Gunn-Diode der oben genannten Art mit besonders hochwertigen Kontakten bereitzustellen, bei denen der Übergangs- oder Kontaktwiderstand besonders gering gehalten ist.

Diese Aufgabe wird erfindungsgemäß gelöst mit den Merkmalen von Anspruch 1.

Die Erfindung geht dabei von der Überlegung aus, dass der Kontaktwiderstand für ein Bauelement der genannten Art besonders gering gehalten werden kann, indem konsequent auch Einzelbeiträge zum Kontaktwiderstand minimiert werden. Als ein wesentlicher Beitrag zum Kontaktwiderstand insgesamt wird dabei neben dem Leitfähigkeitssprung zwischen einem Peripheriematerial, Üblicherweise einem Metall, und dem eigentlichen Material der zur aktiven Schicht benachbarten Schicht auch ein abrupter Übergang zwischen zwei Materialien mit unterschiedlicher Kristallstruktur, bedingt durch die damit einhergehenden mikroskopischen Verzerrungseffekte, angesehen. Dieser kann besonders gering gehalten werden, indem zunächst ausgehend von der eigentlichen Kontaktschicht eine äußere Zone bereitgestellt wird, die zur Vermeidung der genannten Verzerrungseffekte dieselbe Kristallstruktur aufweist wie die Kontaktschicht. Dazu ist diese äußere Zone ebenfalls aus dem selben Material gebildet wie die eigentliche Kontaktschicht. Zur Erleichterung des sich anschließenden elektrischen Übergangs auf die Peripheriekomponenten sollte diese äußere Zone aber eine im Vergleich zur eigentlichen Kontaktschicht deutlich erhöhte Leitfähigkeit aufweisen. Dazu ist die ge nannte äußere Zone im Vergleich zur eigentlichen Kontaktschicht erneut höher dotiert.

Zur Vermeidung von störenden und unerwünschten Elektromigrationen von der Anode zur Kathode ist zudem eine besonders gute örtliche Trennung der beiden Elektroden voneinander wünschenswert. In gezielter Abweichung von der Bauart, bei der die beiden Elektroden auf derselben Seite des Substrats und damit nahe beieinander liegen, ist daher eine Positionierung einer der Elektroden an der Unterseite, also der dem aktiven Schichtpaket abgewandten Seite, des Substrates vorgesehen. Um dies zu ermöglichen, ist in das Substrat mit der angrenzenden Kontaktschicht in der Art eines monolithischen Blocks aus demselben Material mit erhöhter Dotierung gebildet, so dass im Wesentlichen eine der Kontaktschichten das Substrat bildet. Dadurch ist eine gute örtliche Trennung der Anode und Kathode möglich, ohne den Serienwiderstand der gesamten Anordnung zu erhöhen.

Dabei ist der auf dem Substrat befindliche Kontakt an dessen Unterseite angebracht. Die Unterseite ist dabei diejenige Seite, die der aktiven Schicht gegenüber liegt. Damit wird die durch die Abmessungen der Diode begrenzte größtmögliche örtliche Trennung der Anode und Kathode erreicht. Die bei herkömmlichen Gunn-Dioden auftretende Elektromigration von der Anode zur Kathode, welche eine Zerstörung des Bauelements zur Folge hat, wird dadurch besonders gering gehalten.

In vorteilhafter Ausführung bildet die im Vergleich zur Kontaktschicht noch höher dotierte Kontaktierungsschicht den Anodenkontakt.

Das Schichtpaket aus den drei genannten unterschiedlich dotierten Schichten ist in Gunn-Dioden üblicher Bauweise auf einem Substrat angebracht, für das als Basismaterial im Hinblick auf dielektrische Eigenschaften und Kompatibilitätsaspekte mit anderen Komponenten, aber auch Aspekte wie Verfügbarkeit und Verarbeitbarkeit und dergleichen üblicherweise Saphir vorgesehen ist. Um die Kontaktierung der Gunn-Diode in beiden der aktiven Schicht benachbarten Kontaktschichten zu ermöglichen, ist die an das Substrat angrenzende Kontaktschicht von der Grundfläche her in der Regel größer bemessen als die eigentlich aktive Schicht, so dass ein von der aktiven Schicht nicht bedeckter und somit von oben zugänglicher Flächenanteil der unteren Kontaktschicht bereitgestellt ist. In derartiger Bauweise sind somit beide Elektroden der Gunn-Diode auf derselben Seite des Substrats angeordnet. Der Kathodenkontakt wird dabei üblicherweise an der oberen höher dotierten Schicht angebracht und der Anoden kontakt auf der nun frei liegenden Oberseite der unteren höher dotierten Schicht.

Über die durch zu hohe Kontaktwiderstände bedingten Störeinflüsse hinaus können Einschränkungen der betrieblichen Einsetzbarkeit und auch der Lebensdauer von Gunn-Dioden durch unerwünschte thermische Effekte, insbesondere eine Erwärmung der Bauelemente der Gunn-Diode, hervorgerufen werden. Des Weiteren werden Gunn-Dioden bei zu hoher thermischer Erwärmung frequenzinstabil, und bei großer Überhitzung verschwindet der negative differentielle Widerstand, der für die Funktionsweise der Gunn-Diode essentiell ist. Um dem gezielt entgegenzuwirken, ist in vorteilhafter Ausgestaltung die aktive Schicht der Gunn-Diode rückgekühlt. Dazu ist sie zweckmäßigerweise thermisch mit einem Kühlkörper verbunden. Dieser weist vorzugsweise eine hohe thermische Leitfähigkeit auf und kann daher in der aktiven Schicht entstehende thermische Energie ableiten.

Die thermische Leitfähigkeit des Kühlkörpers ist dabei in weiterer vorteilhafter Ausgestaltung höher als die des Substrates. Dies ermöglicht das gezielte Ableiten der thermischen Energie über den Kühlkörper. Um dabei zusätzlich auch noch die im Substrat anfallende thermische Wärme gezielt ableiten zu können, ist in vorteilhafter Weise die thermische Verbindung der aktiven Schicht mit dem Kühlkörper Ober das Substrat hergestellt. Dies hat den Vorteil, dass auch die im Substrat gebildete Wärmeenergie über den Kühlkörper abfließen kann. Da die Wärme hauptsächlich in der aktiven Schicht entsteht, ist ebenfalls eine Wärmeabführung über den Kathodenkontakt aufgrund des geringeren Abstandes zu der aktiven Schicht denkbar.

Bei in Betrieb befindlichen Gunn-Dioden ist es teilweise wünschenswert, die Kühlung sowohl örtlich als auch zeitlich extern steuern zu können. Dazu ist in vorteilhafter Weise der Kühlkörper als Kühlstift ausgebildet. Dies ermöglicht ein gezielteres Einsetzen des Kühlkörpers angepasst an die beim Betrieb der Gunn-Diode tatsächlich auftretende thermische Erwärmung. Des Weiteren ist durch den Einsatz eines Kühlstiftes der Betrieb der Gunn-Dioden bei tiefen Temperaturen möglich, da dort die Gunn-Diode noch sensibler auf Erwärmung reagiert.

Um der Wärmeentwicklung auch an der Kathode Rechnung zu tragen, wird diese in vorteilhafter Ausgestaltung von einer dielektrischen Hülle umgeben. Dazu wird die Gunn-Diode gekapselt und mit einer dielektrischen Flüssigkeit mit hoher Durchbruchfeldstärke und guter thermischer Leitfähigkeit gefüllt.

Eine weitere Möglichkeit, die thermische Erwärmung der aktiven Schicht zu reduzieren, ist, den Sättigungsstrom und damit die Leistung der Gunn-Diode gezielt zu begrenzen. Dazu ist in vorteilhafter Weise die aktive Schicht lateral auf eine Kanalzone begrenzt. Seitlich wird diese dabei von einem neutralisierten Randbereich begrenzt. Hierzu werden bevorzugt Ionen in dem Randbereich implantiert, um die Neutralisierung der aktiven Schicht im Randbereich zu erhalten. Trotz der lateralen Begrenzung der aktiven Schicht auf eine Kanalzone vergrößert sich der Kontaktwiderstand der Kathode in einer derartigen Bauweise nicht wesentlich.

Durch die bei hohen Feldstärken (E>150kV/cm) induzierten elektrischen Entladungen in der Luft beim Betrieb der Gunn-Diode wird die Kathodenmetallisierung mit positiv geladenen Ionen bombardiert. Dies kann dazu führen, dass sich Metallpartikel aus der Kathodenmetallisierung herauslösen und sich an die freie Oberfläche der aktiven Schicht anlagern. Dies kann zu Beeinträchtigungen im Betrieb der Gunn-Diode bzw. zu ihrer Zerstörung führen. Um dem entgegenzuwirken, ist zumindest die Oberfläche der aktiven Schicht vorteilhafterweise mit einer Passivierungsschicht versehen. In üblicher Ausgestaltung ist das Substrat sowohl von der Grundfläche als auch von der Höhe her größer dimensioniert als die aktive Schicht. Das Substrat weist daher eine so genannte Mesa auf, auf der sich die aktive Schicht befindet. Um die Ablagerung der Metallpartikel auf der aktiven Schicht zu minimieren, ist in vorteilhafter Ausgestaltung auch die Mesa komplett mit einer Passivierungsschicht versehen. Diese sollte eine Durchbruchfeldstärke besitzen, die hoch genug ist, um die elektrischen Entladungen in der Luft bei hohen Feldstärken zu unterdrücken. In einer Doppelfunktion minimiert die Passivierungsschicht auch den Oberflächenstrom und verhindert damit die Ablagerung der Metallpartikel an der aktiven Schicht.

Durch die Verwendung von Materialien für die Passivierungsschicht mit guter Wärmeleitfähigkeit, kann die Passivierungsschicht eine weitere Funktion erfüllen. In weiterer vorteilhafter Ausgestaltung ist die Passivierungsschicht daher als Kühlkörper ausgebildet. Geeignete Beschichtungen mit einer im Vergleich zu aktiven Schicht guten Wärmeleitfähigkeit wären beispielsweise eine Diamant- oder Bornitridschicht.

Der Kathodenkontakt der Gunn-Diode kann in einer weiteren vorteilhaften Ausgestaltung mit einer Schutzbeschichtung versehen sein. Diese Schutzbeschichtung sollte aus einem gegen lonenbombardierung vergleichsweise resistenteren Material als die zu schützende Kathodenmetallisierung sein. Bevorzugt kommt dabei Molybdän als Material für die Schutzbeschichtung zum Einsatz.

In besonders vorteilhafter Ausgestaltung ist die Gunn-Diode auf Nitrid-basierten Materialien (beispielsweise GaN) oder auf Oxid-basierten Materialien (beispielsweise ZnO), sogenannte "wide band gap" Materialen, aufgebaut. Dieses dient dabei als gemeinsames Basismaterial, auf dessen Grundlage zweckmäßigerweise mit jeweils geeigneter Dotierung sowohl die aktive Schicht als auch die benachbarten Kontaktschichten und auch die Außenkontaktschicht hergestellt sind. Wie sich überraschend herausgestellt hat, sind bei Gunn-Dioden auf dieser Materialbasis im Vergleich zu herkömmlichen GaAs- bzw. InP-Gunn-Dioden wesentlich höhere Grenzfrequenzen erreichbar. Um die Leistung der Nitrid-basierten beziehungsweise Oxid-basierten Gunn-Diode zu verkleinern und damit vergleichsweise noch stabilere und zuverlässigere Dioden bereitstellen zu können, ist in weiterer vorteilhafter Ausgestaltung die Gunn-Diode zusätzlich zonen- oder bereichsweise mit einem Aluminiumanteil versehen. Durch einen geeignet gewählten Aluminiumanteil kann die Leistung der Gunn-Diode verringert werden, um ihre Stabilität und Lebensdauer zu erhöhen.

Die mit der Erfindung erzielten Vorteile bestehen insbesondere darin, dass durch die Ausrüstung zumindest einer der Kontaktschichten mit der im Vergleich noch höher dotierten Außenkontaktschicht eine räumliche Entkopplung von den Kontaktwiderstand bedingenden Grenzflächenfaktoren, nämlich einem Wechsel der Kristallstrukturen einerseits und einem Sprung in den Leitfähigkeiten andererseits, voneinander ermöglicht ist. Dabei kann in der Art eines ersten Übergangs von der jeweiligen Kontaktschicht in deren Außenkontaktschicht hinein unter Beibehaltung der Kristallstruktur und damit unter Vermeidung von Kristall-Störeffekten zunächst die Leitfähigkeit signifikant erhöht werden, wobei anschließend in der Art eines zweiten Übergangs ausgehend von der Außenkontaktschicht mit vergleichsweise hoher Leitfähigkeit eine Ankopplung an Peripheriekomponenten, Leitungsdrähte oder dergleichen erfolgen. In der Gesamtheit ist damit ein besonders gering gehaltener Gesamt-Kontaktwiderstand beziehungsweise Serienwiderstand erreichbar, der seinerseits besonders gute Bauteileigenschaften wie beispielsweise hohe thermische und elektronische Stabilität unter Vermeidung von störenden Rauschquellen und dergleichen bedingt. Weitere Vorteile liegen in der geringeren Elektromigration, da die beiden Elektroden örtlich getrennt voneinander angebracht sind und sich auf gegenseitigen Flächen der Gunn-Diode befinden. Dies ist möglich, da eine der Kontaktschichten als Substrat verwendet wird. Es können dadurch stabile Gunndioden hergestellt werden, die gegenüber Elektromigration unempfindlich sind und daher eine besonders hohe Leistung erzielen.

Ein Ausführungsbeispiel der Erfindung wird anhand einer Zeichnung näher erläutert. Darin zeigen:
Fig. 1 eine Gunn-Diode auf GaN-Basis, und
Fig. 2 eine Gunn-Diode auf GaN-Basis mit einer lateral verengten aktiven Schicht.

Gleiche Teile sind in beiden Figuren mit denselben Bezugszeichen versehen.

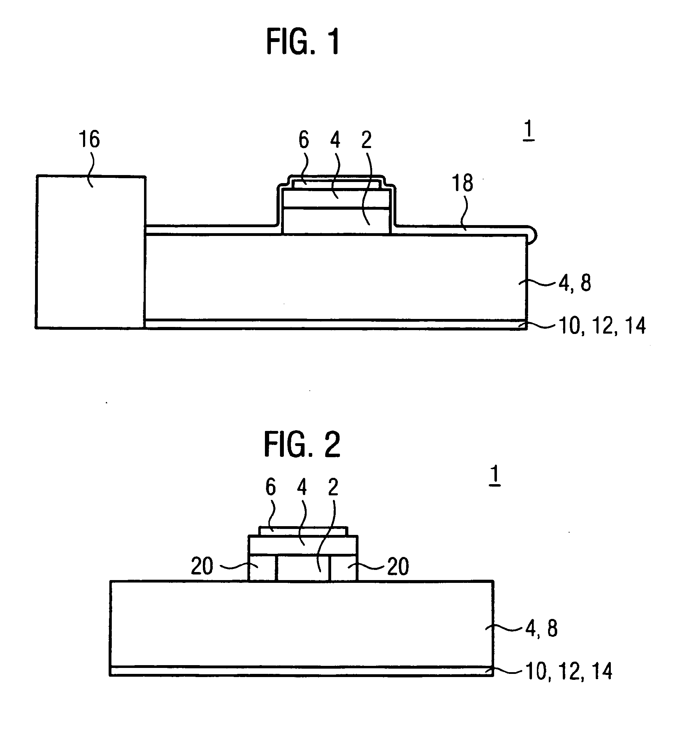

Die Gunn-Diode 1 gemäß Fig. 1 ist in Dünnschicht-Bauweise ausgeführt und umfasst als die elektrischen Eigenschaften des gesamten Bauelements bestimmenden Teil eine n-dotierte so genannte aktive Schicht 2, an deren Ober- und Unterseite jeweils eine höher n-dotierte Schicht aus demselben Basismaterial wie die aktive Schicht 2 als Kontaktschicht 4 angrenzt. Als Basismaterial ist dabei GaN vorgesehen, so dass im Vergleich zu herkömmlichen GaAs- bzw. InP-Gunn-Dioden wesentlich höhere Grenzfrequenzen und Leistungen erreichbar sind. Bedarfsweise kann in ausgewählten geeigneten Bereichen das Basismaterial dabei noch mit einem Aluminiumanteil versehen sein.

Die Einbettung der aktiven Schicht 2 zwischen die beiden benachbarten, höher dotierten Kontaktschichten 4 führt zur Ausbildung von Elektronendomänen an der Kathode infolge des Gunn-Effekts. An der Oberseite der auf der aktiven Schicht 2 angeordneten höher dotierten Kontaktschicht 4 ist wiederum der Kathodenkontakt 6 angebracht.

Anodenseitig und somit bezüglich der unterhalb der aktiven Schicht 2 angeordneten Kontaktschicht 4 ist die Kontaktierung hingegen nicht auf derselben Seite und somit oberseitig des Substrats 8, sondern vielmehr durch das Substrat 8 hindurch auf dessen vom Schichtpaket abgewandter Rückseite vorgesehen. Dazu ist die untere, höher dotierte Kontaktschicht 4 in der Art einer Ausgestaltung als monolithischer Block als Substrat 8 ausgebildet. Die Ausbildung der unteren Kontaktschicht 4 zu einem Substrat 8 ermöglicht dabei insbesondere eine gute örtliche Trennung des Kathodenkontakts 6 und des rückseitig angeordneten Anodenkontakts 10. Dadurch werden Elektromigrationseffekte vom Anodenkontakt 10 zum Kathodenkontakt 6 unterdrückt.

Die Gunn-Diode 1 ist für einen qualitativ besonders hochwertigen und auch störungsfreien rauscharmen Betrieb ausgelegt. Dazu ist unter anderem insbesondere die Kontaktierung derart gewählt, dass die Kontaktwiderstände besonders gering gehalten werden können. Um dies zu gewährleisten, besteht die untere, als Substrat 8 ausgestaltete Kontaktschicht 4 in ihrem zur Bereitstellung des Anodenkontakts 10 vorgesehenen unteren Außenbereich 12 aus einer im Vergleich zur eigentlichen Kontaktschicht 4 noch höher n-dotierten Außenkontaktschicht 14 desselben Basismaterials, also ebenfalls GaN. Damit ist erreichbar, dass unter Beibehaltung der Kristallstruktur der Kontaktschicht 4 die Außenkontaktschicht 14 eine vergleichsweise hohe Leitfähigkeit aufweist, über die eine vergleichsweise einfache und zuverlässige Verbindung mit peripheren Komponenten oder dergleichen hergestellt werden kann.

Durch die besondere Ausführung des Anodenkontaktes 10 ist es möglich, dass die Anodenkontaktierung mit stabilen Materialien, beispielsweise Molybdän oder Wolfram, durchgeführt werden kann, so dass Elektromigration minimiert werden kann. Möglichkeiten die Dotierung des Substrates 8 durchzuführen sind zum Beispiel Diffusion, Ionenimplantation oder epitaktisches Wachstum. Die normale Dotierung der Kontaktschichten 4 liegt im Bereich von 1 bis 5x10¹⁸ cm⁻³. Die höhere Dotierung der Außenkontaktschicht 14 sollte mindestens 10²⁰ cm⁻³ betragen.

Für einen besonders zuverlässigen Betrieb der Gunn-Diode 1 ist diese weiterhin dafür ausgelegt, störende Einflüsse oder betriebliche Instabilitäten aufgrund von Disspipations- oder sonstigen thermischen Effekten besonders gering zu halten. Im Hinblick auf die Erkenntnis, dass in einer Gunn-Diode dieser Bauart Verlustwärme im wesentlichen in der aktiven Schicht 2 erzeugt wird, ist diese thermisch mit einem Kühlkörper 16 aus einem Material vergleichsweise hoher thermischer Leitfähigkeit, insbesondere einem Metall, verbunden. Um dabei zusätzlich auch eventuelle Verlustwärme oder dergleichen zuverlässig aus dem Substrat 8 abführen zu können, ist die thermische Verbindung der aktiven Schicht 2 mit dem Kühlkörper 16, der insbesondere auch als Kühlstift ausgeführt sein kann, über das Substrat 8 hergestellt. Dazu steht der Kühlkörper 16 in direktem mechanischen Kontakt mit dem Substrat 8. Denkbar ist aber auch ein direkter Kontakt des Kühlkörpers 16 mit der aktiven Schicht 2, dem Kathodenkontakt 6 oder auch dem Anodenkontakt 10.

Zum Schutz vor Beschädigung und dergleichen ist zudem der Kathodenkontakt 6 durch eine Passivierungsschicht 18, bestehend aus einer dielektrischen Hülle, umgeben.

In Fig. 2 ist ein weiteres Ausführungsbeispiel der Erfindung dargestellt. Ähnlich wie in Fig. 1 grenzt an die aktive Schicht 2 oberseitig eine Kontaktschicht 4, die mit einem Kathodenkontakt 6 bestückt ist. Unterseitig an die aktive Schicht 2 grenzt das Substrat 8, das aus demselben Material wie die aktive Schicht 2 besteht, allerdings im Vergleich zu dieser höher dotiert ist. An der Unterseite des Substrats 8 befindet sich der Anodenkontakt 10, der aus demselben Material wie das Substrat 8 gebildet ist, nur wiederum höher dotiert. Im Ausführungsbeispiel nach Fig. 2 ist die aktive Schicht 2 lateral jedoch auf einen vorgegebenen Kanalbereich begrenzt und seitlich jeweils von einem neutralen Randbereich 20 umschlossen. Dies kann erreicht werden, indem der Randbereich 20 der aktiven Schicht 2 durch Implantation von Ionen neutralisiert wird.

Durch die Verkleinerung der aktiven Schicht 2 wird erreicht, dass der Sättigungsstrom der Gunn-Diode 1 vermindert wird. Dies führt zu einer geringeren thermischen Erwärmung und damit verbunden einer erhöhten Stabilität und längerer Lebensdauer der Gunn-Diode 1.

### Bezugszeichenliste

- 1: Gunn-Diode
- 2: aktive Schicht
- 4: Kontaktschicht
- 6: Kathodenkontakt
- 8: Substrat
- 10: Anodenkontakt
- 12: Außenbereich
- 14: Außenkontaktschicht
- 16: Kühlkörper
- 18: Passivierungsschicht
- 20: Randbereich

## Patentansprüche

1. Gunn-Diode (1), deren aktive Schicht (2) ober- und unterseitig jeweils an eine benachbarte, im Vergleich zur aktiven Schicht (2) höher dotierte Kontakschicht (4) aus demselben Basismaterial angrenzt, wobei zumindest eine der Kontaktschichten (4) in ihrem Außenbereich (12) aus einer im Vergleich zur jeweiligen Kontaktschicht (4) noch höher dotierten Außenkontaktschicht (14) desselben Materals besteht, **dadurch gekennzeichnet, dass** eine der Kontaktschichten (4) das Substrat (8) bildet, wobei die noch höher dotierte Außenkontaktschicht (14) an der der aktiven Schicht (2) gegenüber liegenden Seite des Substrates (8) angeordnet ist.

2. Gunn-Diode nach Anspruch 1, bei der die Außenkontaktschicht (14) den Anodenkontakt (10) bildet.

3. Gunn-Diode nach einem der Ansprüche 1 bis 2, deren aktive Schicht (2) thermisch mit einem Kühlkörper (16) verbunden ist.

4. Gunn-Diode nach Anspruch 3, bei der die Wärmeleitfähigkeit des Kühlkörpers (16) höher als die ihres Substrates (8) ist.

5. Gunn-Diode nach Anspruch 3 oder 4, bei der die thermische Verbindung der aktiven Schicht (2) mit dem Kühlkörper (16) über das Substrat (8) hergestellt ist.

6. Gunn-Diode nach einem der Ansprüche 3 bis 5, deren Kühlkörper (16) als Kühlstift ausgebildet ist.

7. Gunn-Diode nach einem der Ansprüche 1 bis 6, bei der der Kathodenkontakt (6) von einer dielektrischen Hülle umgeben ist.

8. Gunn-Diode nach einem der Ansprüche 1 bis 7, bei der die aktive Schicht (2) lateral auf eine Kanalzone begrenzt ist, die seitlich jeweils von einem neutralisierten Randbereich (18) begrenzt ist.

9. Gunn-Diode nach einem der Ansprüche 1 bis 8, bei der mindestens die Oberfläche der aktiven Schicht (2) mit einer Passivierungsschicht versehen ist.

10. Gunn-Diode nach Anspruch 9, bei der die Passivierungsschicht als Kühlköper ausgebildet ist.

11. Gunn-Diode nach einem der Ansprüche 1 bis 10, bei der der Kathodenkontakt (6) mit einer Schutzbeschichtung versehen ist.

12. Gunn-Diode nach einem der Ansprüche 1 bis 11, bei der das Basis-Material ein Nitrid-basiertes Material ist.

13. Gunn-Diode nach einem der Ansprüche 1 bis 11, bei der das Basis-Material ein Oxid-basiertes Material.

14. Gunn-Diode nach Anspruch 12 oder 13, bei der das Basismaterial zusätzlich mit einem Aluminiumanteil versehen ist.

## Claims

1. A Gunn diode (1) whose active layer (2) borders with its upper side and its lower side in each case on one adjacent contact layer (4) of the same basic material, with a higher doping than that of the active layer (2), at least one of the contact layers (4) consisting in its outer area (12) of an outer contact layer (14) of the same material, with an even higher doping than that of the respective contact layer (4), **characterized in that** one of the contact layers (4) forms the substrate (8), the outer contact layer (14) with the even higher doping being arranged on that side of the substrate (8) which is opposite the active layer (2).

2. The Gunn diode (1) of claim 1, wherein the outer contact layer (14) forms the anode contact (10).

3. The Gunn diode (1) of any of claims 1 to 2, whose active layer (2) is thermally connected with a heat sink (16).

4. The Gunn diode (1) of claim 3, wherein the thermal conductivity of the heat sink (16) is higher than that of the substrate (8).

5. The Gunn diode (1) of claim 3 or 4, wherein the thermal connection of the active layer (2) with the heat sink (16) is brought about via the substrate (8).

6. The Gunn diode (1) of any of claims 3 to 5, whose heat sink (16) is designed as a cooling pin.

7. The Gunn diode (1) of any of claims 1 to 6, wherein the cathode contact (6) is surrounded by a dielectric covering.

8. The Gunn diode (1) of any of claims 1 to 7, wherein the active layer (2) is laterally limited to a channel zone which is defined on each side by a neutralized margin area (18).

9. The Gunn diode (1) of any of claims 1 to 8, wherein at least the upper surface of the active layer (2) is provided with a passivation layer.

10. The Gunn diode (1) of claim 9, wherein the passivation layer is designed as a heat sink.

11. The Gunn diode (1) of any of claims 1 to 10, wherein the cathode contact (8) is provided with a protective coating.

12. The Gunn diode (1) of any of claims 1 to 11, wherein the basic material is a nitride-based material.

13. The Gunn diode (1) of any of claims 1 to 11, wherein the basic material is an oxide-based material.

14. The Gunn diode (1) of claim 12 or 13, wherein the basic material is additionally provided with an aluminium share.

## Revendications

1. Diode Gunn (1) dont la couche active (2) touche par son côté supérieur et son côté inférieur à chaque fois à une couche de contact (4) adjacente de la même matière de base, avec un dopage plus fort que celui de la couche active (2), au moins une des couches de contact (4) consistant dans sa zone extérieure (12) en une couche de contact extérieure (14) de la même matière, avec un dopage encore plus fort que celui de la couche de contact (4) respective, **caractérisée en ce qu'**une des couches de contact (4) forme le substrat (8), la couche de contact extérieure (14) avec le dopage encore plus fort étant disposée sur le côté du substrat (8) qui est opposé à la couche active (2).

2. Diode Gunn (1) selon la revendication 1, dans laquelle la couche de contact extérieure (14) forme le contact anodique (10).

3. Diode Gunn (1) selon l'une quelconque des revendications 1 à 2, dont la couche active (2) est connectée thermiquement avec un dissipateur thermique (16).

4. Diode Gunn (1) selon la revendication 3, dans laquelle la conductivité thermique du dissipateur thermique (16) est plus grande que celle du substrat (8).

5. Diode Gunn (1) selon la revendication 3 ou 4, dans laquelle la connection thermique de la couche active (2) avec le dissipateur thermique (16) est établie moyennant le substrat (8).

6. Diode Gunn (1) selon l'une quelconque des revendications 3 à 5, dont le dissipateur thermique (16) est conçu comme une broche de refroidissement.

7. Diode Gunn (1) selon l'une quelconque des revendications 1 à 6, dans laquelle le contact cathodique (6) est enveloppé par une gaine diélectrique.

8. Diode Gunn (1) selon l'une quelconque des revendications 1 à 7, dans laquelle la couche active (2) est limitée latéralement à une zone de canal qui est bordée de chaque côté par une zone de marge neutralisée (18).

9. Diode Gunn (1) selon l'une quelconque des revendications 1 à 8, dans laquelle au moins la surface supérieure de la couche active (2) est pourvue d'une couche de passivation.

10. Diode Gunn (1) selon la revendication 9, dans laquelle la couche de passivation est conçue comme un dissipateur thermique.

11. Diode Gunn (1) selon l'une quelconque des revendications 1 à 10, dans laquelle le contact cathodique (8) est pourvu d'un revêtement de protection.

12. Diode Gunn (1) selon l'une quelconque des revendications 1 à 11, dans laquelle la matière de base est une matière à base de nitrure.

13. Diode Gunn (1) selon l'une quelconque des revendications 1 à 11, dans laquelle la matière de base est une matière à base d'oxide.

14. Diode Gunn (1) selon la revendication 12 ou 13, dans laquelle la matière de base est additionnellement pourvu d'une fraction d'aluminium.
